(19) **Europäisches Patentamt**

**European Patent Office**

**Office européen des brevets**

(11) **EP 0 484 246 B1**

(12) **EUROPEAN PATENT SPECIFICATION**

(45) Date of publication and mention
of the grant of the patent:
**10.12.1997 Bulletin 1997/50**

(51) Int Cl.[6]: **H03J 7/18**

(21) Application number: **91402928.5**

(22) Date of filing: **31.10.1991**

(54) **High speed method for searching an alternative frequency in a radio system**

Hochgeschwindigkeitsverfahren zur Suche einer alternativen Frequenz in einem Radiosystem

Procédé à grande vitesse de recherche d'une fréquence alternative dans un système radio

(84) Designated Contracting States:
**DE FR GB IT**

(30) Priority: **31.10.1990 KR 1764990**

(43) Date of publication of application:
**06.05.1992 Bulletin 1992/19**

(73) Proprietor: **LG ELECTRONICS INC.**
**Seoul (KR)**

(72) Inventor: **Kwak, Dong Cheon**
**Anyang, Kyungki-Do (KR)**

(74) Representative: **Fort, Jacques**
**CABINET PLASSERAUD**
**84, rue d'Amsterdam**
**75009 Paris (FR)**

(56) References cited:
**EP-A- 0 275 527**     **DE-A- 3 149 409**
**GB-A- 2 208 457**

# Description

The present invention relates to a searching method for alternative frequency in a radio data system which receives a digital information such as a traffic information, and more particularly to a high-speed processing method for alternative frequency in a radio data system which, in case that the field strength of the broadcasting being presently listening to becomes weaker, searches for alternative frequency list of other broadcasting stations which are sending the same broadcasting program on the air so that the broadcasting signal can be clearly listened to.

In general, digital informations such as a traffic information are converted into a biphase symbol, carrier is omitted therefrom so as to be modulated Into AM 57 KHz and then transmitted by carrying it to a current FM broadcasting signal, and the transmitted signal is received by a receiver such as that of DE-A-3149409 including a radio data system wherein digital information is separated from the FM audio signals and then processed.

Said digital information may include a program Identification indicating countries and regions, a program service name indicating the name of the broadcasting station, a program type indicating the type of the present broadcasting program, a traffic program identification indicating the broadcasting which is sending the traffic information on the air, a traffic announcement identification indicating that the traffic information is sent on the air, and an alternative frequency list indicating the names of other broadcasting stations which are sending the same broadcasting program on the air,

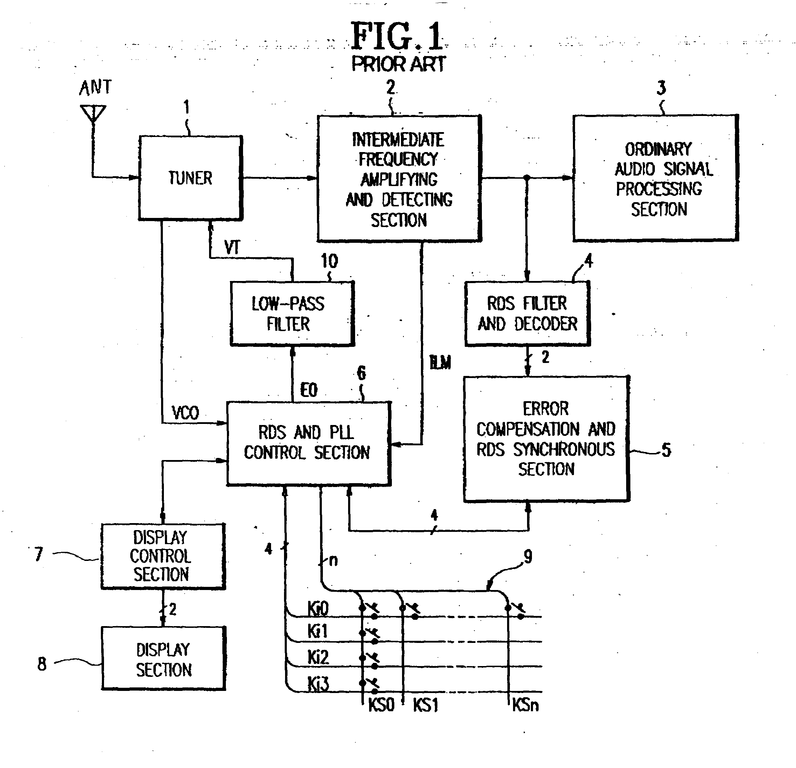

One conventional alternative frequency processing system for use in a radio data system is illustrated In Fig. 1. As shown in Fig. 1, the conventional alternative frequency processing system comprises a tuner 1 for tuning the FM frequency signal which is received through an antenna(ANT), an intermediate frequency amplifying and detecting section 2 for amplifying and detecting the output signal from the tuner 1, an ordinary audio signal processing section 3 for processing an ordinary audio signal among the output signals from the intermediate frequency amplifying and detecting section 2, an RDS filter and a decoder 4 for filtering and decoding a RDS(radio data system) signal among the output signals from the intermediate frequency amplifying and detecting section 2, an error compensating and RDS synchronous section 5 for compensating and synchronizing the error in the output signals from the RDS filter and decoder 4, an RDS and PLL control section 6 for storing in its internal RAM (random access memory) an alternative frequency list contained in the RDS data detected from the error compensating and RDS synchronous section 5 and outputting an error signal Eo in response to a phase comparision by receiving a voltage control oscillation signal VCO from the tuner 1, a low-pass filter 10 for applying a predetermined tuning voltage $V_T$ to the tuner 1 in response to the error signal Eo from the RDS and PLL control section 6, a display control section 7 and a display section 8 each for displaying the RDS data from the RDS and PLL control section 6, and a key matrix 9 for supplying a key signal to the RDS and PLL control section 6.

The conventional alternative frequency processing system operates as follows.

When a RDS broadcasting station is selected at the tuner 1 by a tuning voltage $V_T$ being outputted from the low-pass filter 10, an FM broadcasting signal received through an antenna ANT is tuned and outputted at the tuner 1, and the output signal from the tuner 1 is amplified and detected at the intermediate frequency amplifying and detecting section 2, thereby causing the intermediate frequency amplifying and detecting section 2 to output a combination signal of RDS signals and ordinary audio signals. Among the combination signals, an ordinary audio signal is processed and outputted at the ordinary audio signal processing section 3 so that one can listen to the signal, while the RDS signal is filtered and decoded at the RDS filter and decoder 4 and then outputted as clock signal and data. The output signals are inputted to the error compensating and RDS synchronous section 5 so as to be compensated in their errors and tuned thereat, thereafter the RDS data are applied to the RDS and PLL control section 6. As a result, the RDS and PLL control section 6 controls the display control section 7 to indicate RDS information on the display section 8, and controls the low-pass filter 10 in response to the voltage control oscillation signal VCO being inputted from the tuner 1 so that the tuner 1 maintains a tuning state.

Furthermore, the RDS and PLL control section 6 stores an alternative frequency list of other broadcasting stations which are sending the same program on the air to a specific RAM.

Under these states, when the field strength of the received broadcasting signal becomes weaker so that an intermediate frequency level meter signal ILM outputted from the intermediate frequency amplifying and detecting section 2 is maintained below a certain level over a predetermined time, another broadcasting is searched for on the alternative frequency list stored in the RAM, and at this moment an error signal Eo is outputted in response to the phase difference between the alternative frequency and the voltage controlled oscillation signal VCO by setting the alternative frequency to the phase-locked loop(PLL) as a reference frequency; as a result a tuning voltage $V_T$ outputted from the low-pass filter 10 Is changed to tune the broadcasting signal of another broadcasting station. In this case, If there are a number of broadcasting stations on the alternative frequency list, the searching operation for the broadcasting station is executed randomly.

And, each time the RDS and PLL control section 6 searches for a broadcasting station on the alternative frequency list, the RDS and PLL control section 6 receives the intermediate frequency level meter signal ILM outputted from the intermediate frequency amplifying and detecting section 2 and then stops the searching operation on the alternative frequency list when the intermediate frequency level meter signal ILM is over a predetermined level; as a result the tuner 1 maintains its tuning state.

However, In such a conventional system, since the alternative frequency of other broadcasing stations which are sending the same program on the air is searched for randomly and the tuning voltage is changed by setting the reference frequency of the phase-locked loop each time the alternative frequency Is searched for, it takes a relatively long time in detecting and processing the alternative frequency, thereby the listener is unnecessarily long soudless and also it is impossible to search for the broadcasting signal whose field strength is highest since such a conventional system stops the searching operation when the intermediate frequency level meter signal ILM has first exceeded a predetermined level.

Accordingly, it is an object of the present invention to provide a high-speed processing method in a radio data system which is capable of quickly searching an alternative frequency of another broadcasting station which is sending the same program on the air when an intermediate frequency level meter signal of the presently receiving broadcasting signal is maintained below a predetermined level over a predetermined time, and supplying quickly a tuning voltage in accordance with the alternative frequency to a tuner.

Another object of the present invention is to provide a high-speed processing method which is capable of searching for automatically an alterative frequency of which the reception field strength is highest on the alternative frequency list of other broadcasting station which are sending the same program on the air when the intermediate frequency level meter signal of the presently receiving broadcasting signal is maintained below a predetermined level, and supplying the tuning voltage in accordance with the alterative frequency to the tuner.

Other objects and further scope of applicability of the present invention will become apparent from the detailed description given hereinafter. It should be understood, however, that the detailed description and specific examples, while indicating preferred embodiments of the invention, are given by way of illustration only, since various changes and modifications within the spirit and scope of the invention will become apparent to those skilled In the art from this detailed description.

Briefly described, the present invention relates to a high-speed processing method for alternative frequency in a radio data system according to claim 1.

Other features of the invention are defined in the sub-claims.

The present Invention will become more fully understood from the detailed description given hereinbelow and the accompanying drawings which are given by way of illustration only, and thus are not limitative of the present invention, and wherein:

Fig. 1 Is a block diagram of a conventional alternative processing system in a radio data system;
Fig. 2 is a block diagram of a hardware for executing a high-speed processing method for alternative frequency in a radio data system according to the present invention;
Fig. 3 is a flowchart of the alternative frequency high-speed processing method of the present invention; and
Figs. 4A and 4B are waveform views illustrating the tuning adjusting timings of the conventional system and the present invention.

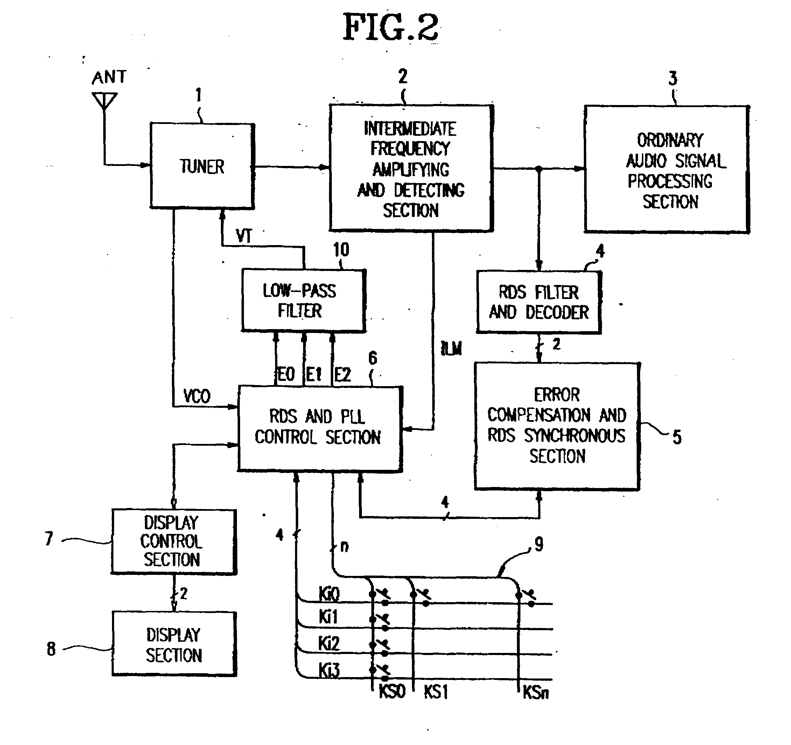

Referring now in detail to the drawings for the purpose of illustrating preferred embodiments of the present invention, the hardware for carrying out the high-speed processing method for alternative frequency in a radio data system as shown in Fig. 2, which comprises a tuner 1 for tuning FM broadcasting signal received through an antenna ANT, an intermediate frequency amplifying and detecting section 2 for amplifying and detecting the output signal from the tuner 1, an ordinary audio signal processing section 3 for processing an ordinary audio signal among the output signals from the intermediate frequency amplifying and detecting section 2, an RDS filter and decoder 4 for filtering and decoding an RDS signal among the output signals from the intermediate frequency amplifying and detecting section 2, an error compensating and RDS synchronous section 5 for compensating and synchronizing an error in the output signals from the RDS filter and decoder 4, an RDS and PLL control section 6 for storing in its internal RAM an alternative frequency list contained in the RDS data detected from the error compensating and RDS synchronous section 5, outputting an error signal $E_o$ in response to the phase difference between the alternative frequency and the voltage controlled oscillation signal VCO from the tuner 1, and outputting rising and falling control pulse signals $E_2$ and $E_1$ before setting the alternative frequency as a reference frequency of a phase-locked loop(PLL), a low-pass filter 10 for applying a predetermined tuning votage $V_T$ to the tuner 1 in response to the error signal $E_o$ and rising and falling control signals $E_2$ and $E_1$ of the RDs and PLL control section 6, a display control section 7 and a display section 8 for indicating the RDS data of the RDS and PLL control section 6, and a key matrix 9 for supplying a key signal to the RDS and PLL control section 6.

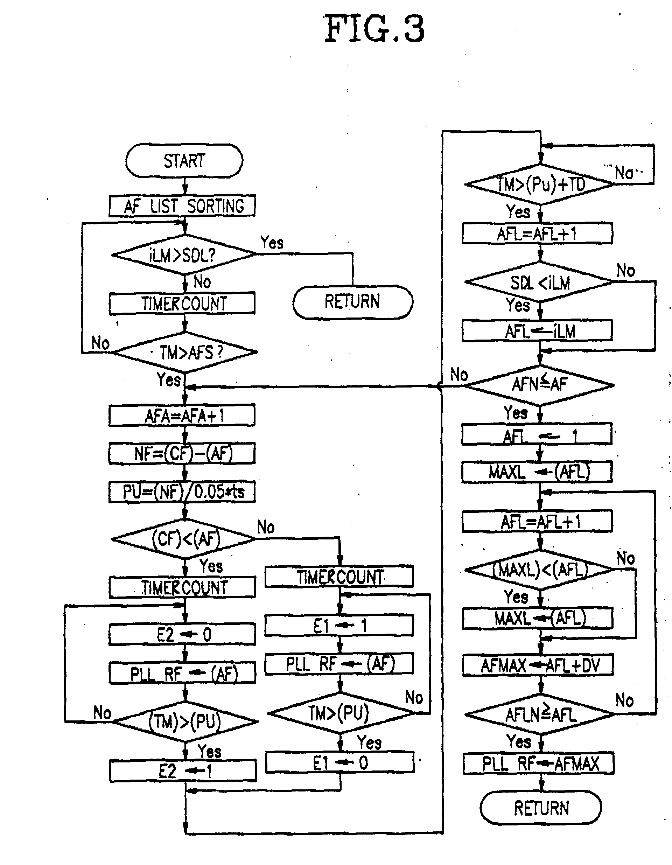

Hereinafter, the high-speed processing method for alternative frequency in a radio system of the present invention will be described in detail with reference to the flowchart of Fig. 3.

When a RDS broadcasting is selected at the tuner 1 by the tuning voltage $V_T$ being outputted from the low-pass filter 10, FM broadcasting signal being received from the antenna ANT is tuned and outputted at the tuner 1, and the output signal of the tuner 1 is amplified and detected at the intermediate frequency amplifying and detecting section 2 so that a combination signal of RDS signal and ordinary audio signal is outputted from the intermediate frequency amplifying and detecting section 2. Among the combination signals thus outputted, an ordinary audio signal separated from the combination signals thus outputted is delivered to the ordinary audio signal processing section 3 processed so that listeners can listen to the audio signal, while the RDS signal is filtered and decoded at the RDS filter and decoder 4 and then outputted an clock signal and data. The output signals are inputted to the error compensating and RDS synchronous section 5 so that an error can be compensated thereat and the RDS signal is synchronized, thereafter the RDS data are applied to the RDS and PLL control section 6. As a result, the RDS and PLL control section 6 controls the display control section 7 so as to indicate RDS information on the display section 8 and controls the low-pass filter 10 with an error signal Eo, if the voltage-controlled oscillation signal VCO being inputted from the tuner 1 is different from the reference frequency of the phase-locked loop, so that the tuner 1 is kept maintained at a tuning-state.

Furthermore, at this moment the RDS and PLL control section 6 sorts an alternative frequency list of other broadcasting stations which are sending the same program on the air and stores the result in a specific RAM.

Under these states, when the field strength of the receiving broadcasting signal becomes weaker so that an intermediate frequency level meter signal ILM outputted from the intermediate frequency amplifying and detecting section 2 is below a predetermined level, the procedures as shown in Fig. 3 are carried out.

That is, when the intermediate frequency level meter signal (ILM) Is below a predetermined limited level (SDL), time is counted by a timer to prevent an erroneous tuning due to noise, and when the counted time(TM) of the timer is greater than an alternative frequency checking start time(AFS), an address of the alternative frequency list RAM(AFA) Is Increased by "1". Eventually, the address of the alternative frequency list RAM (AFA) becomes "1" at the beginning. Thereafter, the difference (AF) between the frequency(CF) of the broadcasting signal of the presently received broadcast signal and the alternative frequency (AF) which has been recorded in a designated address(AFA) of the alternative frequency list RAM is sought and stored, and from the stored frequency diffrerence (NF) a pulse width(PU) indicative of an output width of the rising control signal $E_2$ and the falling control pulse signal $E_1$ is calculated by the following equation and then stored.

$$PU = NF \div 0.05 \text{ x Ts}$$

Wherein, Ts is a pulse width required per step.

Thereafter, a comparison is made whether the frequency(CF) of the presently received broadcasting signal is smaller than the alternative frequency (AF) which is recorded in the designated address(AFA) of the alternative frequency list RAM, and in case the frequency (CF) is smaller than the alternative frequency (AF), the pulse signal $E_2$ is outputted in low level so as to be active. And then, the alternative frequency(AF) is set as a reference frequency of the phase-locked loop and when the counted time (YM) of the timer is greater than the pulse-width(PU), the rising control pulse signal $E_2$ is outputted in high level so as to be inactive.

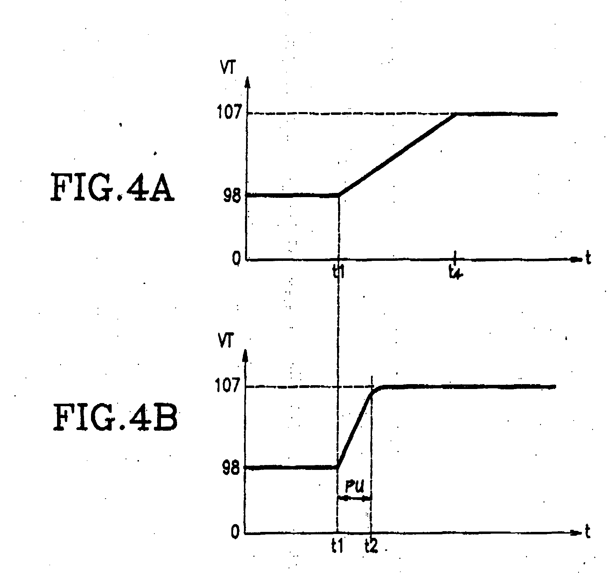

When a low level rising control pulse signal $E_2$ is outputted and applied to the low-pass filter 10, a tuning voltage $V_T$ being outputted from the low-pass filter 10 is rising for a short pulse-width(PU), as shown in Fig. 4B; it is adjusted very fast compared to the case that the tuning voltage $V_T$ is increased gradually by the error signal Eo, as shown in Fig. 4A.

After that, the tuning voltage $V_T$ is adjusted by the error signal Eo in response to the phase difference between the reference frequency which has been set at the phase-locked loop and the voltage-controlled oscillation signal VCO from the tuner 1 so that the tuning state of the tuner 1 is maintained.

Meanwhile, in case that the frequency(CF) of the presently received broadcasting signal is greater than the alternative frequency(AF) recorded in the designated address(AFA) of the alternative frequency list RAM, the time is counted by the timer and the falling control pulse signal $E_1$ is outputted at high level so as to be active. And then, the alternative frequency(AF) is set as a reference frequency of the phase-locked loop. When the counted time(TM) of the timer is greater than the pulse-width(PU), the falling control pulse signal $E_1$ is outputted in low level so as to be inactive. Accordingly, when a high 1 level falling control pulse signal $E_1$ is outputted and amplified to the low-pass filter 10, the tuning voltage $V_T$ outputted from the low-pass filter 10 falls down for a short pulse-width(PU) to a tuning voltage in accordance with the alternative frequency, and thereafter the tuning voltage $V_T$ is adjusted by an error signal Eo in response to the phase difference between the reference frequency which has been set at the phase-locked loop and the voltage-controlled oscillation signal VCO being outputted from the tuner 1 so that the tuning state of the tuner 1 is maintained.

Meanwhile, when the counted time(TM) of the timer is greater than the delay time(TD) required in the practical tuning after the rising and falling control pulse signals $E_2$ and $E_1$ are inactive, that is, when the counted time(TM) of the timer is greater than the value of pulse-width(PU) + delay time(TD) after outputting the rising control pulse signal $E_2$ or the falling control pulse signal $E_1$, the address(AFL) of the RAM which stores the intermediate frequency level meter signal(ILM), is increased by "1" and the intermediate frequency level meter signal(ILM) being outputted from the intermediate frequency amplifying and detecting section 2 is inputted. In case that the intermediate frequency level meter signal(ILM) is greater than a predetermined limiting level(SDL), the intermediate frequency level meter signal(ILM) is stored in the designated address(AFL) of the RAM. While, in case that the intermediate frequency level meter signal (ILM) is smaller than the predetermined limiting level (SDL), it is compared as to whether the designated address(AFA) of the alterative frequency list RAM is greater than the highest address(AFN) of the alternative frequency list RAM, and in case that it is smaller than the highest address(AFN), returning to the step of increasing the address(AFA) of the alternative frequency list RAM by "1" and then executing the next procedures repeatedly.

And, in case that the designated address(AFA) of the alternative frequency list RAM is the same as or greater than the highest address(AFN) of the alternative frequency list RAM, the address(AFL) of the level meter signal storage RAM is set to "1", and the intermediate frequency level meter signal(ILM) stored in the designated address(AFL) is stored in a highest value storage RAM(MAXL) as a highest value. Thereafter, it is checked whether the intermediate frequency level meter signal ILM which has been stored in the designated address(AFL) is greater than the highest value which has been stored in the highest value storage RAM (MAXL) after increasing the address(AFL) of the level meter signal storage RAM by "1". At this moment, in case the intermediate frequency level meter signal(ILM) is greater than the highest value of the highest value storage RAM, the intermediate frequency level meter signal(ILM) is stored again in the highest value storage RAM(MAXL) as a highest value, and thereafter in case the intermediate frequency level meter signal(ILM) is smaller than the highest value stored in the highest value storage RAM(MAXL), an alternative frequency in a accordance with the highest value is sought and stored in an alternative frequency highest RAM(AFMAX). That is, at this moment an alternative frequency is sought by adding a differential frequency(DC) in accordance with the relationship between the alternative frequency(AF) and the intermediate frequency level meter signal(ILM) to the highest value which has been read by the highest value storage RAM(MAXL), and then stored in the alternative frequency highest RAM(AFMAX). Thereafter, in case that the designated address(AFL) of the level meter signal storage RAM is smaller than the highest address(AFLN) of the level meter signal storage RAM, returning to the step of increasing the address(AFL) of the level meter signal storage RAM by "1" and executing the next procedures repeatedly. While, if the designated address(AFL) is the same as or greater than the highest address(AFLM) of the level meter signal storage RAM, the alternative frequency stored in the alternative frequency highest RAM(AFMAX) is read out and then set as a reference frequency of the phase-locked loop.

As described above in detail, the present invention provides the effect that, since when a field strength of the presently received broadcasting signal is maintained in a level below a predetermined level over a predetermined time, an alternative frequency is consecutively searched for in the alternative frequency list, a rising or falling control pulse signal is outputted so as to reach a tuning voltage in accordance with the alternative frequency and the alternative frequency is set to a reference frequency of a phase-locked loop, it is possible to tune at the alternative frequency more quickly. Furthermore, since the highest alternative frequency whose field strength of the received broadcasting signal is highest is searched for and tuned thereto, it is possible to provide the listeners with convenience and reliability.

**Claims**

1. A high-speed processing method for alternative frequency in a radio data system comprising the steps of:

   a) sorting and storing an alternative frequency list contained in the data of a radio data system;
   b) designating an address of said alternative frequency list RAM(AFA) when an intermediate frequency level meter signal of a received broadcasting signal remains at a level below a predetermined value (SDL);
   c) comparing an alternative frequency (AF) stored in the designated address with a frequency of the broadcasting signal which is currently received;
   d) outputting rising and falling control pulse signals $(E_2, E_1)$ for controlling the rising and falling of a tuning voltage $(V_T)$ in response to the result of step c) for a predetermined time (PU), and setting the alternative frequency as a reference frequency of a phase-locked loop;
   e) storing an intermediate frequency level meter signal (ILM) of the received broadcast signal when it is over a predetermined level;
   f) returning to the step b) if the designated address of step b) is not the highest value, or designating the address in which the intermediate frequency level meter signal is stored if the designated address is the highest value;
   g) searching for the highest intermediate frequency level meter signal by reading in order the intermediate frequency level meter signal which has been stored in the designated address (AFL), and seeking an alternative frequency corresponding to the highest intermediate frequency level meter signal; and
   h) setting the alternative frequency obtained at step g) as a reference frequency of the phase-locked loop.

**2.** The method of claim 1, wherein the first address is designated at first at the first step a) and when returning from the step e), designating the address after increasing by "1".

**3.** The method of claim 2, wherein the address of the alternative frequency list is designated at step b), therafter seeking the difference between the alternative frequency which has been stored in the designated address and the frequency of the presently receiving broadcasting signal, and seeking and storing a pulse-width of rising and falling control pulses by the difference signal and a pulse-width signal required per step.

**4.** The method of claim 3, wherein, when the alternative frequency (AF) of step c) is greater than the frequency (CF) of the received broadcast signal, a rising control of the received broadcasting signal, a rising control pulse ($E_2$) is outputted for an interval of the stored pulse-width and the alternative frequency (AF) is set as a reference frequency of the phase-locked loop, while when the alternative frequency is smaller than the frequency of the receiving broadcasting signal, a falling control pulse is outputted for an interval of the stored pulse-width and the alternative frequency is set as a reference frequency of the phase-locked loop at step d).

**5.** The method of claim 1, wherein the first address in which the intermediate frequency level meter signal has been stored is designated at step f).

**6.** The method of claim 1, wherein the intermediate frequency level meter signal which has been stored in the address designated at step f) is read out and stored as a highest intermediate frequency level meter signal, and thereafter the intermediate frequency level meter signal which has been stored in the designated address is read out while increasing the address by "1", and when the intermediate frequency level meter signal (ILM) is greater than the stored highest intermediate frequency level meter signal, the intermediate frequency level meter signal is stored again as a highest intermediate frequency level meter signal in a highest value storage RAM (MAXL), thereby searching for the highest intermediate frequency level meter signal at the step g).

**Patentansprüche**

**1.** Hochgeschwindigkeitsverfahren zur Suche einer alternativen Frequenz in einem Radiodatensystem umfassend die Schritte:

    a) Sortieren und Speichern einer Liste alternativer Frequenzen, die in den Daten eines Radiodatensystems enthalten ist;
    b) Zuweisen einer Adresse der Liste alternativen Frequenzen RAM (AFA), wenn ein Zwischenfrequenzniveau-Meßsignal eines empfangenen Übertragungssignals bei einem Niveau unterhalb eines vorgegebenen Wertes (SDL) bleibt;
    c) Vergleichen einer alternativen Frequenz (AF), die in der ausgewählten Adresse gespeichert ist, mit einer Frequenz des Übertragungssignales, welches augenblicklich empfangen wird;
    d) Ausgeben von Anhebungs- und Absenkungs-Steuerimpulssignalen ($E_2$, $E_1$) zum Steuern des Anhebens und des Absenkens einer Abstimmungsspannung ($V_T$) in Abhängigkeit von dem Resultat des Schrittes c) während einer vorgegebenen Zeitdauer (PU) und Einstellen der alternativen Frequenz als Referenzfrequenz einer phasenstarren Schleife;
    e) Speichern eines Zwischenfrequenzniveau-Meßsignals (ILM) des empfangenen Übertragungssignales, wenn es über einem vorgegebenen Niveau liegt;
    f) Zurückkehren zu dem Schritt b), wenn die zugeordnete Adresse von Schritt b) nicht der höchste Wert ist, oder Zuweisen der Adresse, in der das Zwischenfrequenzniveau-Meßsignal gespeichert ist, wenn die zugeordnete Adresse der höchste Wert ist;
    g) Suchen nach dem höchsten Zwischenfrequenzniveau-Meßsignal, indem der Reihe nach das Zwischenfrequenzniveau-Meßsignal gelesen wird, welches in der zugeordneten Adresse (AFL) gespeichert worden ist, und Suchen einer alternativen Frequenz, die dem höchsten Zwischenfrequenzniveau-Meßsignal entspricht; und
    h) Einsetzen der alternativen Frequenz, die bei dem Schritt g) erhalten wurden, als Referenzfrequenz der phasenstarren Schleife.

**2.** Verfahren nach Anspruch 1, worin die erste Adresse zuerst bei dem ersten Schritt a) zugewiesen wird und, wenn eine Rückkehr von dem Schritt e) stattfindet, Zuweisen der Adresse nach Erhöhen um "1".

**3.** Verfahren nach Anspruch 2, worin die Adresse der Liste alternativer Frequenzen bei Schritt b) zugewiesen wird, wonach die Differenz zwischen der alternativen Frequenz, die in der zugeordneten Adresse gespeichert worden ist, und der Frequenz des augenblicklich empfangenen Übertragungssignales gesucht wird, und worin eine Impulsbreite von Anhebungs- und Absenkungs-Steuerimpulsen durch das Differenzsignal und ein Impulsbreitensignal, welches pro Schritt benötigt wird, gesucht und gespeichert wird.

**4.** Verfahren nach Anspruch 3, worin, wenn die alternative Frequenz (AF) des Schrittes c) größer als die Frequenz (CF) des empfangenen Übertragungssignales ist, zur Steuerung im Sinne einer Anhebung des empfangenen Übertragungssignale ein Anhebungs-Steuerimpuls ($E_2$) während eines Intervalls der gespeicherten Impulsbreite ausgegeben wird, und daß die alternative Frequenz (AF) als eine Referenzfrequenz der phasenstarren Schleife eingestellt wird, während, wenn die alternative Frequenz kleiner als die Frequenz des empfangenen Übertragungssignales ist, ein Absenkungs-Steuerimpuls während eines Intervalles der gespeicherten Impulsbreite ausgegeben wird und die alternative Frequenz als Referenzfrequenz der phasenstarren Schleife bei dem Schritt d) eingestellt wird.

**5.** Verfahren nach Anspruch 1, worin die erste Adresse, in der das Zwischenfrequenzniveau-Meßsignal gespeichert worden ist, beim Schritt f) zugewiesen wird.

**6.** Verfahren nach Anspruch 1, worin das Zwischenfrequenzniveau-Meßsignal, welches in der beim Schritt f) zugewiesenen Adresse gespeichert worden ist, ausgelesen und als höchstes Zwischenfrequenz-Meßsignal gespeichert wird, und wobei danach das Zwischenfrequenzniveau-Meßsignal, welches in der zugewiesenen Adresse gespeichert worden ist, ausgelesen wird, während die Adresse um „1" erhöht wird, und worin, wenn das Zwischenfrequenzniveau-Meßsignal (ILM) größer als das gespeicherte höchste Zwischenfrequenzniveau-Meßsignal ist, das Zwischenfrequenzniveau-Meßsignal wieder als ein höchstes Zwischenfrequenzniveau-Meßsignal in einem Speicher für den höchsten Wert RAM (MAXL) gespeichert wird, wodurch nach dem höchsten Zwischenfrequenzniveau-Meßsignal beim Schritt g) gesucht wird.

**Revendications**

**1.** Un procédé de traitement rapide concernant une fréquence de remplacement dans un système de transmission de données par radio, comprenant les étapes suivantes :

    a) on trie et on enregistre une liste de fréquences de remplacement qui est contenue dans les données d'un système de transmission de données par radio;

    b) on désigne une adresse de la mémoire vive de liste de fréquences de remplacement (AFA) lorsqu'un signal d'appareil de mesure de niveau à fréquence intermédiaire d'un signal de radiodiffusion reçu reste à un niveau inférieur à une valeur prédéterminée (SDL);

    c) on compare une fréquence de remplacement (AF) enregistrée à l'adresse désignée avec la fréquence du signal de radiodiffusion qui est reçu au moment présent;

    d) on émet des signaux d'impulsions de commande de montée et de descente ($E_2$, $E_1$) pour commander la montée et la descente d'une tension d'accord ($V_T$), sous l'effet du résultat de l'étape c), pendant une durée prédétermine (PU), et on prend la fréquence de remplacement à titre de fréquence de remplacement d'une boucle d'asservissement de phase;

    e) on enregistre un signal d'appareil de mesure de niveau à fréquence intermédiaire (ILM) du signal de radiodiffusion reçu, lorsqu'il est supérieur à un niveau prédéterminé;

    f) on retourne à l'étape b) si l'adresse désignée de l'étape b) n'est pas la valeur la plus élevée, ou bien on désigne l'adresse à laquelle est enregistré le signal d'appareil de mesure de niveau à fréquence intermédiaire si l'adresse désignée est la valeur la plus élevée;

    g) on recherche le signal d'appareil de mesure de niveau à fréquence intermédiaire le plus élevé, en lisant dans l'ordre le signal d'appareil de mesure de niveau à fréquence intermédiaire qui a été enregistré à l'adresse désignée (AFL), et on cherche une fréquence de remplacement qui correspond au signal d'appareil de mesure de niveau à fréquence intermédiaire le plus élevé; et

    h) on prend à titre de fréquence de référence de la boucle d'asservissement de phase la fréquence de remplacement qui est obtenue à l'étape g).

**2.** Le procédé de la revendication 1, dans lequel la première adresse est désignée initialement à la première étape a), et au moment du retour à partir de l'étape e), on désigne l'adresse après l'avoir augmentée de "1".

**3.** Le procédé de la revendication 2, dans lequel on désigne l'adresse de la liste de fréquences de remplacement à l'étape b), on cherche ensuite la différence entre la fréquence de remplacement qui a été enregistrée à l'adresse désignée et la fréquence du signal de radiodiffusion qui est reçu au moment présent, et on cherche et on enregistre une largeur d'impulsion pour des impulsions de commande de montée et de descente, sur la base du signal de différence et d'un signal de largeur d'impulsion qui est exigé pour chaque pas.

**4.** Le procédé de la revendication 3, dans lequel, lorsque la fréquence de remplacement (AF) de l'étape c) est supérieure à la fréquence (CF) du signal de radiodiffusion reçu, c'est-à-dire dans le cas d'une commande de montée du signal de radiodiffusion reçu, une impulsion de commande de montée ($E_2$) est émise pendant un intervalle égal à la largeur d'impulsion enregistrée, et la fréquence de remplacement (AF) est prise à titre de fréquence de référence de la boucle d'asservissement de phase, tandis que lorsque la fréquence de remplacement est inférieure à la fréquence du signal de radiodiffusion reçu, une impulsion de commande de descente est émise pendant un intervalle égal à la largeur d'impulsion enregistrée, et la fréquence de remplacement est prise à titre de fréquence de référence de la boucle d'asservissement de phase à l'étape d).

5. Le procédé de la revendication 1, dans lequel la première adresse à laquelle a été enregistré le signal d'appareil de mesure de niveau à fréquence intermédiaire est désignée à l'étape f).

6. Le procédé de la revendication 1, dans lequel le signal d'appareil de mesure de niveau à fréquence intermédiaire qui a été enregistré à l'adresse désignée à l'étape f) est lu et enregistré à titre de signal d'appareil de mesure de niveau à fréquence intermédiaire le plus élevé, et ensuite le signal d'appareil de mesure de niveau à fréquence intermédiaire qui a été enregistre à l'adresse désignée est lu tandis que l'adresse est augmentée de "1", et lorsque le signal d'appareil de mesure de niveau à fréquence intermédiaire (ILM) est supérieur au signal d'appareil de mesure de niveau à fréquence intermédiaire enregistré, le signal d'appareil de mesure de niveau à fréquence intermédiaire est enregistré à nouveau à titre de signal d'appareil de mesure de niveau à fréquence intermédiaire le plus élevé, dans une mémoire vive d'enregistrement de valeur la plus élevée (MAXL), pour rechercher ainsi le signal d'appareil de mesure de niveau à fréquence intermédiaire le plus élevé à l'étape g).

FIG. 1
PRIOR ART

EP 0 484 246 B1

# FIG.2

# FIG.3

FIG.4A

FIG.4B